# EUROPEAN PATENT APPLICATION

(11) **EP 4 645 705 A1**
(43) Date of publication of application: **05.11.2025**
(21) Application number: 24741296.8
(22) Date of filing: 10.01.2024
(51) Int. Cl.: H03M 7/30

(54) **DATA COMPRESSION METHOD, APPARATUS AND SYSTEM, DATA DECOMPRESSION METHOD, APPARATUS AND SYSTEM, AND MEDIUM**

(30) Priority: 12.01.2023 CN 202310074697
(71) Applicant: Huawei Technologies Co., Ltd., Shenzhen, Guangdong 518129 (CN)
(72) Inventor: ZHENG, Kai, Shenzhen, Guangdong 518129 (CN); HU, Dingsheng, Shenzhen, Guangdong 518129 (CN); SHEN, Yaodong, Shenzhen, Guangdong 518129 (CN); WU, Chaohao, Shenzhen, Guangdong 518129 (CN)
(74) Representative: Thun, Clemens
(86) International application number: PCT/CN2024/071645
(87) International publication number: WO 2024/149300

(57) **Abstract**

This application discloses a data compression method, a data decompression method, apparatus, and system, and a medium, and pertains to the computer field. The method includes: obtaining a codeword corresponding to to-be-compressed first original data; and obtaining first compressed data corresponding to the first original data, where the first compressed data includes first indication information and the codeword, and the first indication information indicates a length of the codeword. According to this application, a compression rate can be improved.

## Description

This application claims priority to Chinese Patent Application No. 202310074697.6, filed on January 12, 2023 and entitled "DATA COMPRESSION METHOD, DATA DECOMPRESSION METHOD, APPARATUS, AND SYSTEM, AND MEDIUM", which is incorporated herein by reference in its entirety.

### TECHNICAL FIELD

This application relates to the computer field, and in particular, to a data compression method, a data decompression method, apparatus, and system, and a medium.

### BACKGROUND

A computing chip may compress original data to obtain compressed data, and store the compressed data in an off-chip memory. When the computing chip needs to use the original data, the computing chip reads the compressed data from the off-chip memory, and decompresses the compressed data to obtain the original data. However, a compression rate implemented by the computing chip for the original data is usually low, and effect of compressing the original data is not high.

### SUMMARY

This application provides a data compression method, a data decompression method, apparatus, and system, and a medium, to improve a compression rate. Technical solutions are as follows.

According to a first aspect, this application provides a data compression method. In the method, a codeword corresponding to to-be-compressed first original data is obtained. First compressed data corresponding to the first original data is obtained, where the first compressed data includes first indication information and the codeword, and the first indication information indicates a length of the codeword. The first original data is compressed into the codeword, and the length of the codeword is less than or equal to a length of the first original data, so that a compression rate may be improved. In addition, because the first indication information indicates the length of the codeword, algorithm complexity of allocating the codeword corresponding to the first original data may be simplified, thereby improving compression efficiency.

In a possible implementation, occurrence frequency of each type of original data included in a to-be-compressed first original data segment and a quantity of types of original data included in the first original data segment are obtained, where the first original data segment is a data segment to which the first original data belongs. The codeword corresponding to the first original data is obtained based on the occurrence frequency of each type of original data included in the first original data segment and the quantity of types of original data included in the first original data segment. Because the codeword corresponding to the first original data is obtained based on the occurrence frequency of each type of original data included in the first original data segment, higher occurrence frequency of the first original data indicates a shorter length of the codeword obtained for the first original data, so that the compression rate may be improved.

In another possible implementation, a first compression mode is obtained based on the quantity of types of original data included in the first original data segment, where a plurality of codeword lengths are defined in the first compression mode, a quantity of types of original data that can be compressed in the first compression mode is greater than or equal to the quantity of types of original data included in the first original data segment, and the quantity of types of original data that can be compressed in the first compression mode is determined based on the plurality of codeword lengths. The codeword corresponding to the first original data is obtained based on the plurality of codeword lengths defined in the first compression mode and the occurrence frequency of each type of original data included in the first original data segment, where the length that is of the codeword and that is indicated by the first indication information is one of the plurality of codeword lengths. Because the codeword corresponding to the first original data is obtained based on the occurrence frequency of each type of original data included in the first original data segment and the plurality of codeword lengths defined in the first compression mode, higher occurrence frequency of the first original data leads to a shorter length of the codeword obtained for the first original data, so that the compression rate may be improved.

In another possible implementation, a first length is obtained, where the first length is equal to a sum of lengths of compressed data corresponding to all original data in a first original data block, and the first original data block is an original data block to which the first original data belongs. When the first length is less than a standard block length, a first compressed data block corresponding to the first original data block is obtained, where the first compressed data block includes at least one padding bit and the compressed data corresponding to all original data in the first original data block, and a quantity of the at least one padding bit is equal to the standard block length minus the first length. In this way, a length of each compressed data block is the standard block length, thereby facilitating decompression of the compressed data block.

In another possible implementation, the first original data block is a data block in the first original data segment, a first compressed data segment corresponding to the first original data segment includes a compressed data block corresponding to each original data block in the first original data segment, the first compressed data segment further includes a data header, the data header includes the first compression mode, and the length of the codeword is equal to one of the plurality of codeword lengths defined in the first compression mode. Because the data header includes the first compression mode, during decompression, the length of the codeword can be accurately obtained based on the first compression mode and the first indication information, thereby ensuring that the data may be correctly obtained through decompression.

In another possible implementation, the first compressed data segment further includes a first correspondence, and the first correspondence includes the first original data and the codeword. In this way, during data decompression, the data may be successfully obtained through decompression based on the first correspondence.

In another possible implementation, the first original data segment includes a plurality of pieces of first data at consecutive positions, the first original data includes second indication information and a quantity of the plurality of pieces of first data, and the second indication information indicates that the first original data includes the quantity of the plurality of pieces of first data. In this way, the plurality of pieces of first data may be compressed into one piece of compressed data, thereby improving the compression rate.

In another possible implementation, the first original data segment includes second data, the second data is data other than the first data, the first original data includes third indication information and the second data, and the third indication information indicates that the first original data includes the second data.

According to a second aspect, this application provides a data decompression method. In the method, to-be-decompressed first compressed data is obtained, where the first compressed data includes first indication information and a codeword, and the first indication information indicates a length of the codeword. First original data is obtained based on the first indication information and the codeword. The first compressed data includes the first indication information and the codeword, and the length of the codeword is less than or equal to a length of the first original data, so that a compression rate may be improved. In addition, because the first indication information indicates the length of the codeword, algorithm complexity of allocating the codeword corresponding to the first original data may be simplified, thereby improving compression efficiency.

In a possible implementation, a first original data segment to which the first original data belongs includes a plurality of original data blocks, the plurality of original data blocks include a first original data block, the first original data block includes the first original data, a first compressed data block corresponding to the first original data block includes compressed data corresponding to all original data in the first original data block, a sum of lengths of all compressed data included in the first compressed data block is equal to a first length, the first length is less than a standard block length, the first compressed data block further includes at least one padding bit, and a quantity of the at least one padding bit is equal to the standard block length minus the first length. In this way, a length of each compressed data block is the standard block length, thereby facilitating decompression of the compressed data block.

In another possible implementation, a first compressed data segment corresponding to the first original data segment includes a compressed data block corresponding to each original data block in the first original data segment, the first compressed data segment further includes a data header, the data header includes a first compression mode, a plurality of codeword lengths are defined in the first compression mode, a quantity of types of original data that can be compressed in the first compression mode is greater than or equal to a quantity of types of original data included in the first original data segment, the quantity of types of original data that can be compressed in the first compression mode is determined based on the plurality of codeword lengths, and the length that is of the codeword and that is indicated by the first indication information is one of the plurality of codeword lengths. The codeword is obtained from the first compressed data based on the first indication information and the first compression mode. The first original data corresponding to the codeword is obtained. Because the data header includes the first compression mode, the codeword can be accurately obtained based on the first compression mode and the first indication information, thereby ensuring that the data may be correctly obtained through decompression.

In another possible implementation, the first compressed data segment further includes a first correspondence, and the first correspondence includes the first original data and the codeword. The first original data corresponding to the codeword is obtained based on the first correspondence. Because the first compressed data segment includes the first correspondence, the first original data may be successfully obtained through decompression based on the first correspondence.

In another possible implementation, the first original data is obtained based on the first indication information and the codeword by using m decoder groups, where each decoder group includes n decoders, n is equal to a quantity of the plurality of codeword lengths defined in the first compression mode, m is equal to |L/S|, L is a length of the first compressed data block, S is a greatest common divisor of n numerical values, the n numerical values include a sum of a codeword length defined in the first compression mode and a length of the first indication information, and | | is a round-down operation. In this way, the data is decompressed in parallel by using the m decoder groups, thereby improving decompression efficiency.

In another possible implementation, a bit sequence is input to a j^{th} decoder in an i^{th} decoder group, where the bit sequence includes an (i*S)^{th} bit to an ((i+j+1)*S-1)^{th} bit in the first compressed data block, i=0, 1, 2, ..., or m-1, j=0, 1, 2, ..., or n-1, and * represents a multiplication operation, so that the decoder obtains, based on the first compression mode, a codeword length indicated by first Q bits of the bit sequence, where Q is the length of the first indication information; and when a length of a first part is equal to the codeword length indicated by the first Q bits, and the first part is the same as the codeword, obtains the first original data corresponding to the codeword, where the first part is a part that is in the bit sequence and that is other than the first Q bits. Because the (i*S)^{th} bit to the ((i+j+1)*S-1)^{th} bit in the first compressed data block are input to the j^{th} decoder in the i^{th} decoder group, the m decoder groups may decompress the first compressed data block in parallel, thereby improving the decompression efficiency.

In another possible implementation, the first original data includes second indication information and a quantity of a plurality of pieces of first data, and the second indication information indicates the quantity that is of the plurality of pieces of first data and that is included in the first original data. The plurality of pieces of first data are obtained based on the second indication information and the quantity. In this way, the plurality of pieces of first data may be compressed into one piece of compressed data, thereby improving the compression rate.

In another possible implementation, the first original data includes third indication information and second data, the third indication information indicates that the first original data includes the second data, and the second data in the first original data is obtained based on the third indication information.

According to a third aspect, this application provides a data compression apparatus, configured to perform the method in any one of the first aspect or the possible implementations of the first aspect. Specifically, the apparatus includes units configured to perform the method in any one of the first aspect or the possible implementations of the first aspect.

According to a fourth aspect, this application provides a data decompression apparatus, configured to perform the method in any one of the second aspect or the possible implementations of the second aspect. Specifically, the apparatus includes units configured to perform the method in any one of the second aspect or the possible implementations of the second aspect.

According to a fifth aspect, this application provides a data compression apparatus, including at least one processor and a memory. The at least one processor is configured to be coupled to the memory, and read and execute instructions in the memory, to implement the method in any one of the first aspect or the possible implementations of the first aspect.

According to a sixth aspect, this application provides a data decompression apparatus, including at least one processor and a memory. The at least one processor is configured to be coupled to the memory, and read and execute instructions in the memory, to implement the method in any one of the second aspect or the possible implementations of the second aspect.

According to a seventh aspect, this application provides a computer program product. The computer program product includes a computer program stored in a computer-readable storage medium, and the computer program is loaded by a processor to implement the method in the first aspect, the second aspect, any possible implementation of the first aspect, or any possible implementation of the second aspect.

According to an eighth aspect, this application provides a computer-readable storage medium, configured to store a computer program. The computer program is loaded by a processor to perform the method in the first aspect, the second aspect, any possible implementation of the first aspect, or any possible implementation of the second aspect.

According to a ninth aspect, this application provides a chip, including a memory and a processor. The memory is configured to store computer instructions, and the processor is configured to invoke the computer instructions from the memory and run the computer instructions, to perform the method in the first aspect, the second aspect, any possible implementation of the first aspect, or any possible implementation of the second aspect.

According to a tenth aspect, this application provides a data decompression system. The system includes the apparatus according to the third aspect and the apparatus according to the fourth aspect, or the system includes the apparatus according to the fifth aspect and the apparatus according to the sixth aspect.

### BRIEF DESCRIPTION OF DRAWINGS

FIG. 1 is a diagram of a computing device according to an embodiment of this application;
FIG. 2 is a diagram of a compression mode according to an embodiment of this application;
FIG. 3 is a diagram of another computing device according to an embodiment of this application;
FIG. 4 is a flowchart of a data compression method according to an embodiment of this application;
FIG. 5 is a flowchart of a codeword allocation method according to an embodiment of this application;
FIG. 6 is a diagram of an original data segment and a compressed data segment according to an embodiment of this application;
FIG. 7 is a flowchart of a data decompression method according to an embodiment of this application;
FIG. 8 is a diagram of data decompression according to an embodiment of this application;
FIG. 9 is a diagram of a decoder group according to an embodiment of this application;
FIG. 10 is a diagram of a structure of a data compression apparatus according to an embodiment of this application;
FIG. 11 is a diagram of a structure of a data decompression apparatus according to an embodiment of this application;
FIG. 12 is a diagram of a structure of another data compression apparatus according to an embodiment of this application; and
FIG. 13 is a diagram of a structure of another data decompression apparatus according to an embodiment of this application.

### DESCRIPTION OF EMBODIMENTS

The following further describes in detail implementations of this application with reference to accompanying drawings.

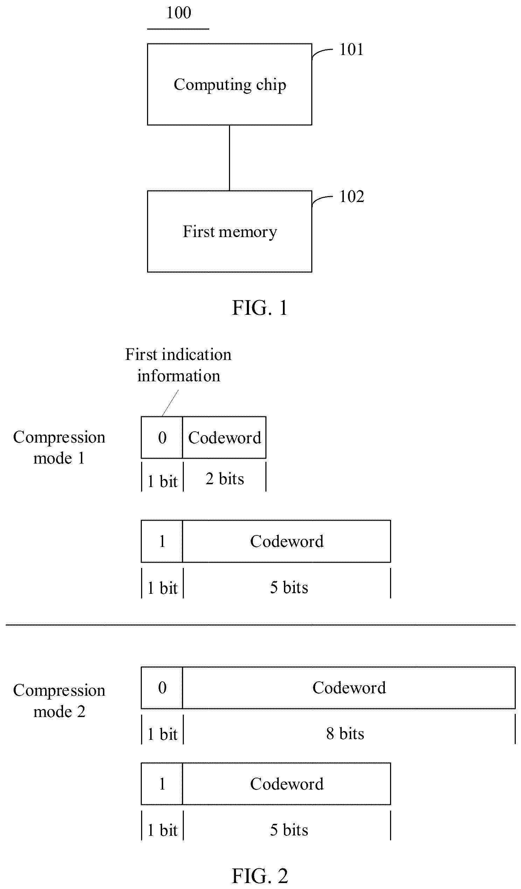

Refer to FIG. 1. An embodiment of this application provides a computing device 100. The computing device 100 includes a computing chip 101 and a first memory 102.

The first memory 102 is configured to store data, and the computing chip 101 is configured to obtain the data stored in the first memory 102 and process the obtained data.

The data stored in the first memory 102 may be compressed data obtained through compression. Compared with original data before compression, the compressed data obtained through compression may have a data volume that is less than a data volume of the original data.

In some embodiments, the data stored in the first memory 102 may be stored in the computing chip 101.

The computing chip 101 may obtain a plurality of pieces of to-be-compressed original data, and many pieces of original data in the plurality of pieces of original data may repeatedly occur. Each piece of original data in the plurality of pieces of original data is compressed to obtain compressed data corresponding to each piece of original data, and all compressed data obtained is stored in the first memory 102, thereby reducing occupied storage resources of the first memory 102.

In some embodiments, a quantity of the plurality of pieces of original data is usually very large. For example, millions, tens of millions, or hundreds of millions of pieces of original data may need to be compressed. However, there may be several, dozens of, or more than a hundred types of original data in the very large quantity of original data, that is, a large quantity of original data in the very large quantity of original data repeatedly occurs.

For example, the plurality of pieces of to-be-compressed original data include 1, 2, 3, 4, 5, 4, 3, 1, 2, 5, 4, 2, 3, 4, 1, 3, and 2, there are five types of original data in total in the plurality of pieces of original data, the five types of original data are 1, 2, 3, 4, and 5, and each of the five types of original data repeatedly occurs.

In some embodiments, this embodiment of this application may be applied to an inference scenario of a neural network, and the plurality of pieces of original data may be network parameters of the neural network. A quantity of network parameters of a neural network is usually very large. For example, a commonly used convolutional neural network includes tens of millions of network parameters. For another example, a quantity of network parameters included in a generative pre-training (generative pre-training, GPT) model in the natural language processing field reaches hundreds of millions.

In an inference scenario of a neural network, network parameters of the neural network may remain unchanged. However, each time the neural network is used for inference, the network parameters of the neural network are repeatedly used for a plurality of times. Therefore, the computing chip 101 may first compress the network parameters of the neural network offline, and store compressed network parameters in the first memory 102. Each time the computing chip 101 uses the neural network for inference, the computing chip 101 obtains the compressed network parameters from the first memory 102, performs online decompression, and performs inference by using decompressed network parameters.

For any piece of original data, the computing chip 101 compresses the original data, to obtain compressed data corresponding to the original data. The compressed data includes first indication information and a codeword corresponding to the original data, and the first indication information indicates a length of the codeword.

In some embodiments, the computing chip 101 may select one compression mode from at least one compression mode. A plurality of codeword lengths are defined in the selected compression mode, and the length that is of the codeword and that is indicated by the first indication information is one of the plurality of codeword lengths.

For any compression mode, a quantity of a plurality of codeword lengths defined in the compression mode is limited by a length of the first indication information. For example, if the length of the first indication information is 1 bit, the quantity of the plurality of codeword lengths defined in the compression mode does not exceed 2, that is, one or two codeword lengths may be defined in the compression mode. If the length of the first indication information is 2 bits, the quantity of the plurality of codeword lengths defined in the compression mode does not exceed 4, that is, one, two, three, or four codeword lengths may be defined in the compression mode.

For example, refer to FIG. 2. The at least one compression mode includes a compression mode 1 and a compression mode 2, and the length of the first indication information is 1 bit. Two codeword lengths are defined in the compression mode 1, and the two codeword lengths are respectively 2 bits and 5 bits. Two codeword lengths are defined in the compression mode 2, and the two codeword lengths are respectively 5 bits and 8 bits.

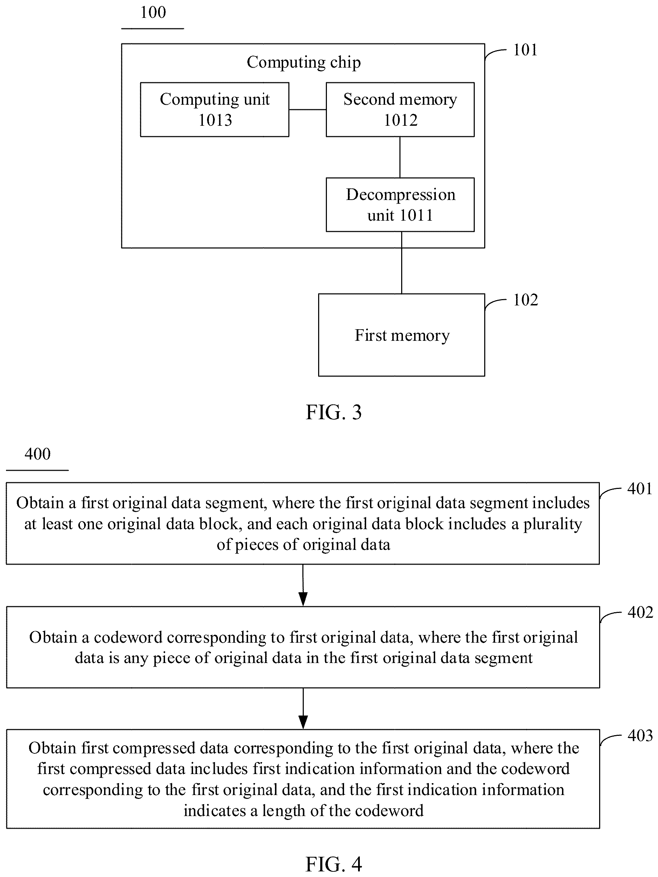

Refer to FIG. 3. The computing chip 101 includes a decompression unit 1011, a second memory 1012, and a computing unit 1013.

Optionally, the decompression unit 1011 may obtain compressed data from the first memory 102, decompress the compressed data to obtain original data, and store the original data in the second memory 102. The computing unit 1013 may obtain the original data from the second memory 102 and process the original data.

Alternatively, the computing chip 101 obtains compressed data from the first memory 102, and stores the compressed data in the second memory 1012. When the computing unit 1013 needs to process data, the decompression unit 1011 obtains the compressed data from the second memory 1012, decompresses the compressed data to obtain original data, and inputs the original data to the computing unit 1013, and the computing unit 1013 processes the original data.

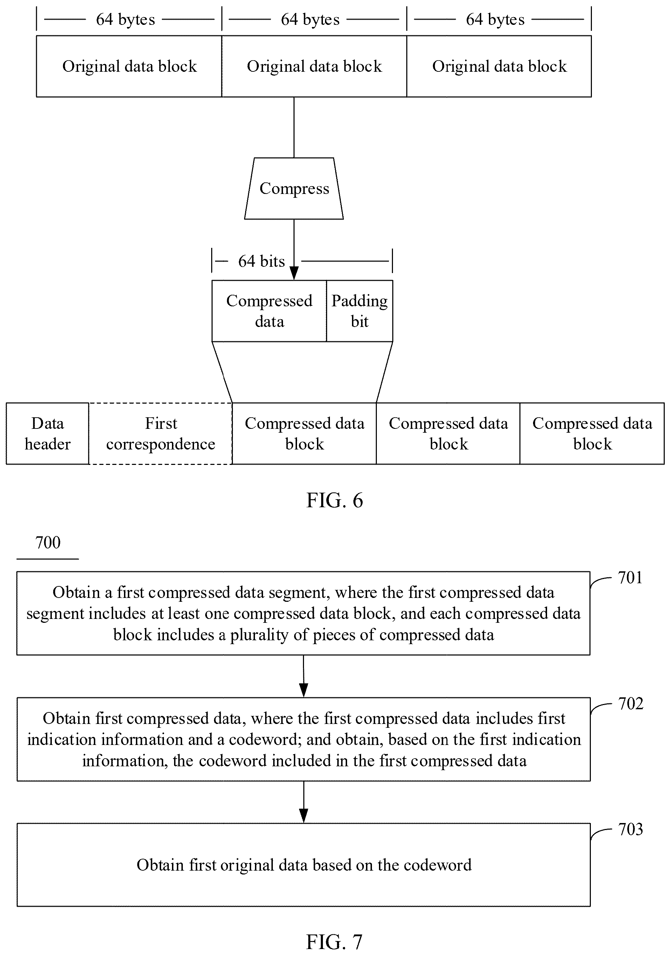

Then, the foregoing data compression process is described by using an embodiment shown in FIG. 4 below, and the foregoing data decompression process is described by using an embodiment shown in FIG. 7.

Refer to FIG. 4. An embodiment of this application provides a data compression method 400. The method 400 is applied to the computing device 100 shown in FIG. 1 or FIG. 3. The method 400 may be performed by the computing chip in the computing device 100. The method 400 includes the following procedure of step 401 to step 403.

Step 401: Obtain a first original data segment, where the first original data segment includes at least one original data block, and each original data block includes a plurality of pieces of original data.

In step 401, a to-be-compressed first data segment is obtained, the first data segment includes a plurality of pieces of to-be-compressed data, and the first original data segment is obtained based on the first data segment.

The first data segment includes a plurality of pieces of to-be-compressed data, and a quantity of the plurality of pieces of to-be-compressed data may be very large. A quantity of pieces of to-be-compressed data that may be included in the first data segment may be hundreds, thousands, tens of thousands, or the like, but a quantity of types of to-be-compressed data included in the first data segment may be relatively small. Optionally, the quantity of types of to-be-compressed data included in the first data segment may be several, a dozen, dozens, or the like, and the first data segment includes to-be-compressed data that repeatedly occurs.

For example, it is assumed that a length of each piece of to-be-compressed data included in the first data segment is 8 bits, the to-be-compressed data may be an integer greater than or equal to 0 and less than or equal to 127, and the quantity of types of to-be-compressed data included in the first data segment is less than or equal to 128, but a quantity of pieces of to-be-compressed data included in the first data segment may be far greater than 128.

It is assumed that the to-be-compressed data included in the first data segment is 1, 2, 3, 0, 0, 0, 4, 5, 2, 1, 3, 0, 0, 0, 0, 0, 1, 2, 3, 4, 0, 2, 0, 4, 1, 3, 5, 4, 2, and 5. The first data segment includes 30 pieces of to-be-compressed data, but the first data segment includes six types of to-be-compressed data. The six types of to-be-compressed data are 0, 1, 2, 3, 4, and 5, and each type of to-be-compressed data repeatedly occurs.

In step 401, an operation of obtaining the first original data segment based on the first data segment may be:
Each piece of to-be-compressed data in the first data segment may be used as original data, that is, the first data segment is used as the first original data segment.

Alternatively, for a sequence that is in the first data segment and that includes a plurality of pieces of first data at consecutive positions, statistics on a quantity of the plurality of pieces of first data in the sequence are collected, and original data corresponding to the sequence is obtained. The original data includes second indication information and the quantity of the plurality of pieces of first data, and the second indication information indicates the quantity that is of the plurality of pieces of first data and that is included in the original data.

The first data is specified data, the first data segment may include at least one sequence, and each sequence is a plurality of pieces of first data at consecutive positions. In this case, original data corresponding to each sequence is obtained in step 301.

For other data that is in the first data segment and that is other than the at least one sequence, for ease of description, the other data is referred to as second data, and original data corresponding to the second data is obtained. The original data includes third indication information and the second data, and the third indication information indicates the second data included in the original data. In this way, the first original data segment is obtained, and the first original data segment includes the original data corresponding to each sequence and original data corresponding to each piece of second data.

For example, it is assumed that the first data is 0, and the to-be-compressed data included in the first data segment is 1, 2, 3, 0, 0, 0, 4, 5, 2, 1, 3, 0, 0, 0, 0, 0, 1, 2, 3, 4, 0, 2, 0, 4, 1, 3, 5, 4, 2, and 5. The first data segment includes two sequences. A first sequence is 0, 0, and 0, and obtained original data corresponding to the first sequence includes second indication information and a quantity 3 of 0s in the first sequence. A second sequence is 0, 0, 0, 0, and 0, and obtained original data corresponding to the second sequence includes second indication information and a quantity 5 of 0s in the second sequence.

Data other than the first sequence and the second sequence is second data, and there are 22 pieces of second data in total. Original data corresponding to each piece of second data is obtained, and original data corresponding to any piece of second data includes third indication information and the second data. For example, for second data "1", original data corresponding to the second data includes third indication information and the second data "1"; for second data "2", original data corresponding to the second data includes third indication information and the second data "2"; and for second data "3", original data corresponding to the second data includes third indication information and the second data "3". For the remaining 19 pieces of second data, original data corresponding to the 19 pieces of second data is not listed one by one. In this way, the first original data segment includes the original data corresponding to the first sequence, the original data corresponding to the second sequence, and original data corresponding to the 22 pieces of second data.

In some embodiments, the quantity of pieces of first data in the sequence is an 8-bit numerical value, and the second indication information is a 1-bit numerical value. Therefore, the original data corresponding to the sequence has 9 bits in total. For any piece of second data, the second data is an 8-bit numerical value, and the third indication information is a 1-bit numerical value. Therefore, original data corresponding to the second data has 9 bits in total.

In some embodiments, a length of each original data block in the first original data segment may be equal to a first standard block length. Alternatively, in the first original data segment, lengths of some original data blocks are equal to the first standard block length, and lengths of some original data blocks are less than the first standard block length.

For example, it is assumed that the first standard block length is 64 bytes, and the length of each original data block in the first original data segment is equal to 64 bytes. Alternatively, in the first original data segment, lengths of some original data blocks are equal to 64 bytes, and lengths of some original data blocks are less than 64 bytes.

Step 402: Obtain a codeword corresponding to first original data, where the first original data is any piece of original data in the first original data segment.

In step 402, occurrence frequency of each type of original data included in the first original data segment and a quantity of types of original data included in the first original data segment are obtained. The codeword corresponding to the first original data is obtained based on the occurrence frequency of each type of original data included in the first original data segment and the quantity of types of original data included in the first original data segment.

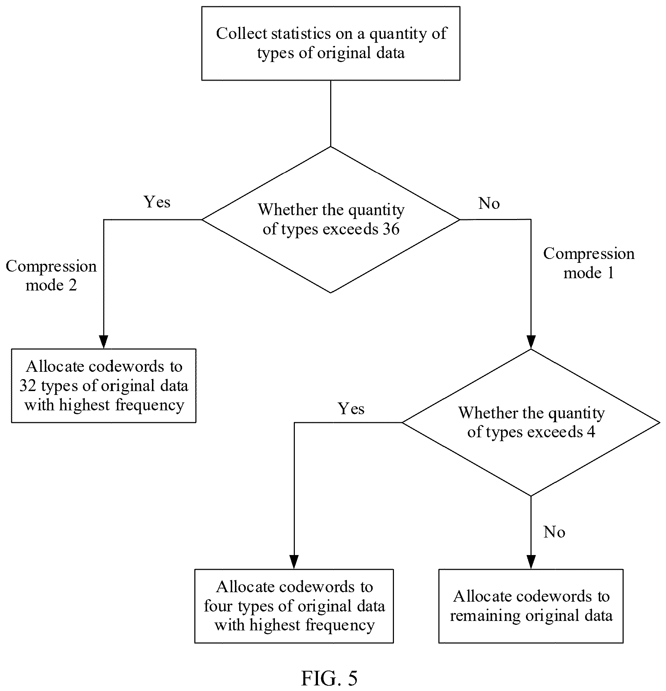

Refer to FIG. 5. In step 402, the codeword corresponding to the first original data may be obtained through the following operations 4021 to 4024.

4021: Collect statistics on the occurrence frequency of each type of original data included in the first original data segment and the quantity of types of original data included in the first original data segment.

4022: Obtain a first compression mode based on the quantity of types of original data included in the first original data segment.

A plurality of codeword lengths are defined in the first compression mode, a quantity of types of original data that can be compressed in the first compression mode is greater than or equal to the quantity of types of original data included in the first original data segment, and the quantity of types of original data that can be compressed in the first compression mode is determined based on the plurality of codeword lengths.

In some embodiments, at least one compression mode may be preconfigured, a plurality of codeword lengths are defined in each compression mode, and a quantity of types of original data that can be compressed in each compression mode is determined based on the plurality of codeword lengths defined in each compression mode. Based on the quantity of types of original data included in the first original data segment, the first compression mode in which the quantity of types of original data that can be compressed is greater than or equal to the quantity of types of original data included in the first original data segment is selected from the at least one compression mode.

For example, refer to FIG. 2. A compression mode 1 and a compression mode 2 are preconfigured. Two codeword lengths are defined in the compression mode 1, and the two codeword lengths are respectively 2 bits and 5 bits. Therefore, four codewords with a length of 2 bits and 32 codewords with a length of 5 bits may be configured for the compression mode 1, that is, 36 codewords may be configured for the compression mode 1, and 36 different pieces of original data may be compressed by using the 36 codewords. That is, a quantity of types of original data that can be compressed in the compression mode 1 is 36.

Two codeword lengths are defined in the compression mode 2, and the two codeword lengths are respectively 5 bits and 8 bits. Therefore, 32 codewords with a length of 5 bits and 128 codewords with a length of 8 bits may be configured for the compression mode 2. The quantity of types of original data included in a first compressed data segment does not exceed 128, that is, 128 codewords may be configured for the compression mode 2, and 128 different pieces of original data may be compressed by using the 128 codewords. That is, a quantity of types of original data that can be compressed in the compression mode 2 is 128.

Refer to FIG. 5. If the quantity of types of original data included in the first original data segment does not exceed 36, the selected first compression mode is the compression mode 1. If the quantity of types of original data included in the first original data segment exceeds 36, the selected first compression mode is the compression mode 2.

4023: Obtain, based on a plurality of codeword lengths defined in the first compression mode and the occurrence frequency of each type of original data included in the first original data segment, a codeword corresponding to each type of original data, and correspondingly store each type of original data and the codeword corresponding to each type of original data in a first correspondence.

In 4023, a codeword is allocated to each type of original data in the first original data segment. For original data with higher occurrence frequency, a length of a codeword allocated to the original data is shorter, and the length of the codeword is one of the plurality of codeword lengths defined in the first compression mode.

For example, refer to FIG. 5. If the quantity of types of original data included in the first original data segment does not exceed 36, the selected first compression mode is the compression mode 1, four pieces of original data with highest occurrence frequency are selected from the first original data segment, a corresponding codeword is allocated to each piece of original data in the four pieces of original data, and a length of the codeword corresponding to each piece of original data is 2 bits. Then, a corresponding codeword is allocated to each piece of remaining unselected original data in the first original data segment, and a length of the codeword corresponding to each piece of unselected original data is 5 bits.

If the quantity of types of original data included in the first original data segment exceeds 36, the selected first compression mode is the compression mode 2, 32 pieces of original data with highest occurrence frequency are selected from the first original data segment, a corresponding codeword is allocated to each piece of original data in the 32 pieces of original data, and a length of the codeword corresponding to each piece of original data is 5 bits. For each piece of remaining unselected original data in the first original data segment, a codeword corresponding to each piece of unselected original data may be each piece of unselected original data.

4024: Obtain, based on the first original data, the codeword corresponding to the first original data from the first correspondence.

Step 403: Obtain first compressed data corresponding to the first original data, where the first compressed data includes first indication information and the codeword corresponding to the first original data, and the first indication information indicates a length of the codeword.

For other original data other than the first original data in the first original data segment, the operations in step 402 and step 403 are performed on the other original data to obtain compressed data corresponding to the other original data. That is, based on the other original data, a codeword corresponding to the other original data is obtained from the first correspondence, and compressed data corresponding to the other original data is obtained. The compressed data includes first indication information and the codeword corresponding to the other original data. In this way, compressed data corresponding to all original data in the first original data segment may be obtained.

Refer to FIG. 6. The first original data segment includes at least one original data block. For any original data block, for ease of description, the original data block is referred to as a first original data block, and each piece of original data in the first original data block is compressed to obtain a first compressed data block corresponding to the first original data block. The first compressed data block includes compressed data corresponding to all original data in the first original data block.

In some embodiments, a length of the first original data block may be equal to the first standard block length, or a length of the first original data block may be less than the first standard block length.

In some embodiments, refer to FIG. 6. A sum of lengths of compressed data corresponding to all original data in the first original data block is obtained, to obtain a first length. When the first length is less than a second standard block length, a first compressed data block corresponding to the first original data block is obtained. The first compressed data block includes at least one padding bit and the compressed data corresponding to all original data in the first original data block, and a quantity of the at least one padding bit is equal to the second standard block length minus the first length. When the first length is equal to the second standard block length, a first compressed data block corresponding to the first original data block is obtained. The first compressed data block includes the compressed data corresponding to all original data in the first original data block. Optionally, the second standard block length may be 64 bits.

In some embodiments, refer to FIG. 6. The first original data segment includes at least one original data block, and each piece of original data in the first original data segment is compressed to obtain a first compressed data segment corresponding to the first original data segment. The first compressed data segment includes a data header and a compressed data block corresponding to each original data block in the first original data segment, and the data header includes the first compression mode.

In some embodiments, refer to FIG. 6. The first compressed data segment further includes the first correspondence.

Optionally, a second correspondence is obtained. The second correspondence is used to store each type of original data in an original data segment compressed last time and a codeword corresponding to each type of original data. When the second correspondence does not include the codeword corresponding to each type of original data in the first correspondence, the first compressed data segment further includes the first correspondence. When the second correspondence includes the codeword corresponding to each type of original data in the first correspondence, the first compressed data segment may not include the first correspondence.

After the first compressed data segment is obtained, the first compressed data segment may be stored in the first memory.

In this embodiment of this application, the occurrence frequency of each type of original data in the first original data segment and the quantity of types of original data in the first original data segment are obtained. The codeword is allocated to each type of original data in the first original data segment based on the occurrence frequency of each type of original data in the first original data segment and the quantity of types of original data in the first original data segment. For any piece of original data in the first original data segment, a codeword corresponding to the original data is obtained, and compressed data corresponding to the original data is obtained. The compressed data includes first indication information and the codeword corresponding to the original data, and the first indication information indicates a length of the codeword. Generally, a length of the codeword corresponding to the original data is less than or equal to a length of the original data, so that a compression rate can be improved. The compressed data corresponding to the original data includes the first indication information, and the first indication information indicates the length of the codeword. In this way, operation complexity of allocating the codeword corresponding to each type of original data may be simplified, thereby improving compression efficiency.

Refer to FIG. 7. An embodiment of this application provides a data decompression method 700. The method 700 is applied to the computing device 100 shown in FIG. 1 or FIG. 3. The method 700 may be performed by the computing chip in the computing device 100. The method 700 includes the following procedure of step 701 to step 703.

Step 701: Obtain a first compressed data segment, where the first compressed data segment includes at least one compressed data block, and each compressed data block includes a plurality of pieces of compressed data.

In some embodiments, the first memory stores the first compressed data segment. The computing chip reads the first compressed data segment from the first memory, then decompresses each piece of compressed data in the first compressed data segment to obtain original data corresponding to each piece of compressed data, and stores the original data corresponding to each piece of compressed data in the second memory. Then, the computing unit in the computing chip processes the original data in the second memory. For a process of decompressing each piece of compressed data, refer to the following process of steps 702 and 703.

Alternatively, in some embodiments, the first memory stores the first compressed data segment. The computing chip reads the first compressed data segment from the first memory, and stores the first compressed data segment in the second memory. When the computing unit in the computing chip needs to process data, each piece of compressed data in the first compressed data segment stored in the second memory is decompressed to obtain original data corresponding to each piece of compressed data, and then the computing unit in the computing chip processes each piece of original data obtained through decompression. For a process of decompressing each piece of compressed data, refer to the following process of steps 702 and 703.

Step 702: Obtain first compressed data, where the first compressed data includes first indication information and a codeword; and obtain, based on the first indication information, the codeword included in the first compressed data, where the first compressed data is any piece of compressed data in the first compressed data segment.

Refer to FIG. 6. The first compressed data segment includes a data header and a data part, and the data part includes at least one compressed data block; or the first compressed data segment includes a data header, a first correspondence, and a data part, the data part includes at least one compressed data block, and the first correspondence is located between the data header and the data part. In step 702, each piece of compressed data is read one by one from a start position of the data part included in the first compressed data segment.

During implementation, first indication information is read from the start position of the data part included in the first compressed data segment, a codeword length indicated by the first indication information is determined, and a codeword is obtained from the data part based on the codeword length, so that a first piece of compressed data is obtained. Then, first indication information continues to be read from the data part, a codeword length indicated by the first indication information is determined, and a codeword is obtained from the data part based on the codeword length, so that a second piece of compressed data is obtained. The foregoing process continues to be performed, so that a third piece of compressed data, a fourth piece of compressed data, a fifth piece of compressed data, ..., are obtained.

In some embodiments, the data header includes a first compression mode, and each time a codeword length indicated by first indication information is to be determined, the codeword length indicated by the first indication information is determined based on the first compression mode.

For example, it is assumed that the first compression mode included in the data header is the compression mode 1 in FIG. 2. When the first indication information is a bit 0, the codeword length indicated by the first indication information is 2 bits. When the first indication information is a bit 1, the codeword length indicated by the first indication information is 5 bits. First indication information is obtained by reading 1 bit (which is a first bit of the data part) from the start position of the data part included in the first compressed data segment. Assuming that the first indication information is the bit 0, it is determined that a codeword length indicated by the first indication information is 2 bits. Based on the codeword length, 2 bits (which are a second bit and a third bit of the data part) are read from the data part, and the 2 bits are used as one codeword, so that a first piece of compressed data is obtained.

First indication information is obtained by continuing to read 1 bit (which is a fourth bit of the data part) from the data part. Assuming that the first indication information is the bit 1, it is determined that a codeword length indicated by the first indication information is 5 bits. Based on the codeword length, 5 bits (which are a fifth bit to a ninth bit of the data part) are read from the data part, and the 5 bits are used as one codeword, so that a second piece of compressed data is obtained.

First indication information is obtained by continuing to read 1 bit (which is a tenth bit of the data part) from the data part. Assuming that the first indication information is still the bit 1, it is determined that a codeword length indicated by the first indication information is 5 bits. Based on the codeword length, 5 bits (which are an eleventh bit to a fifteenth bit of the data part) are read from the data part, and the 5 bits are used as one codeword, so that a third piece of compressed data is obtained. The foregoing process continues to be performed, so that a fourth piece of compressed data, a fifth piece of compressed data, a sixth piece of compressed data, ..., are obtained.

Step 703: Obtain first original data based on the codeword.

If the first compressed data segment includes the first correspondence, the first original data is obtained based on the codeword and the first correspondence. If the first compressed data segment does not include the first correspondence, a second correspondence included in a compressed data segment decompressed last time is obtained, and the first original data is obtained based on the codeword and the second correspondence.

In step 703, for a codeword included in the first piece of compressed data, original data corresponding to the codeword is obtained based on the codeword and the first correspondence, or original data corresponding to the codeword is obtained based on the codeword and the second correspondence. For a codeword included in the second piece of compressed data, original data corresponding to the codeword is obtained based on the codeword and the first correspondence, or original data corresponding to the codeword is obtained based on the codeword and the second correspondence. The foregoing process is repeated, so that original data corresponding to a codeword in each piece of compressed data in the first compressed data segment may be obtained.

In some embodiments, the obtained original data includes second indication information and a quantity of a plurality of pieces of first data, the second indication information indicates the quantity that is of the plurality of pieces of first data and that is included in the original data, and the plurality of pieces of first data may be further obtained based on the second indication information and the quantity. Alternatively, the obtained original data includes third indication information and second data, the third indication information indicates that the original data includes the second data, and the second data in the original data is obtained based on the third indication information.

For any other piece of obtained original data, second data in the original data or a plurality of pieces of first data are obtained based on indication information included in the original data, so that a first data segment corresponding to the first compressed data segment may be obtained.

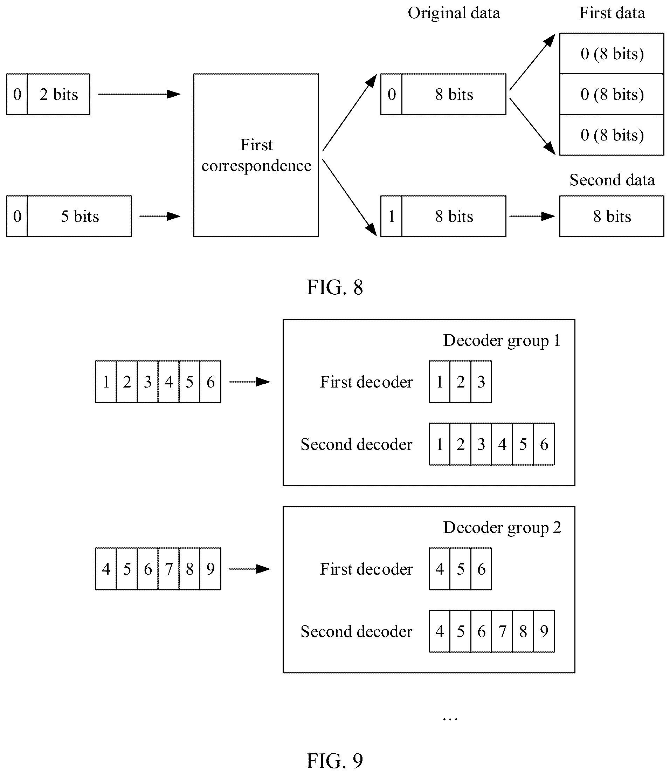

For example, refer to FIG. 8. It is assumed that the first data is 0. For any piece of compressed data, the first correspondence is searched based on a codeword included in the compressed data, and corresponding original data is found from the first correspondence. A length of the original data is 9 bits, and a first bit of the original data is second indication information or third indication information. It is assumed that the second indication information is a bit 0, and the third indication information is a bit 1. If the first bit of the original data is 0, a second bit to a ninth bit of the original data are a quantity of a plurality of 0s, and the plurality of 0s are obtained based on the quantity. If the first bit of the original data is 1, the second bit to the ninth bit of the original data are second data before compression, and the second bit to the ninth bit are obtained as the second data.

In some embodiments, the first compressed data segment includes at least one compressed data block. To improve decompression efficiency, m decoder groups may be used to decompress one compressed data block in parallel. That is, original data corresponding to each piece of compressed data in the compressed data block is obtained by using the m decoder groups. Each decoder group includes n decoders, n is equal to a quantity of a plurality of codeword lengths defined in the first compression mode, m is equal to |L/S|, L is a length of a first compressed data block, S is a greatest common divisor of n numerical values, the n numerical values include a sum of a codeword length defined in the first compression mode and a length of the first indication information, and ∥ is a round-down operation.

For any compressed data block, a bit sequence is input to a j^{th} decoder in an i^{th} decoder group. The bit sequence includes an (i*S)^{th} bit to an ((i+j+1)*S-1)^{th} bit in the compressed data block, i=0, 1, 2, ..., or m-1, j=0, 1, 2, ..., or n-1, and * represents a multiplication operation.

The decoder obtains, based on the first compression mode, a codeword length indicated by first Q bits of the bit sequence, Q is the length of the first indication information, and the first Q bits are the first indication information. When a length of a first part is equal to the codeword length indicated by the first Q bits, and the first part is the same as a codeword in a target correspondence, original data corresponding to the codeword is obtained, where the first part is a part that is in the bit sequence and that is other than the first Q bits, and the target correspondence is the first correspondence or the second correspondence. When the length of the first part is not equal to the codeword length indicated by the first Q bits, or when the first part is different from each codeword in the target correspondence, the bit sequence is discarded, where the first part is a part that is in the bit sequence and that is other than the first Q bits.

For example, it is assumed that the first compression mode is the compression mode 1. Two codeword lengths are defined in the compression mode 1, and are respectively a codeword length of 2 bits and a codeword length of 5 bits, and a length that is of the first indication information and that is defined in the compression mode 1 is 1 bit, that is, n=2. S=3 is a greatest common divisor of a numerical value 3 and a numerical value 6, the numerical value 3 is a sum of the codeword length 2 and the length of the first indication information, and the numerical value 6 is a sum of the codeword length 5 and the length of the first indication information. Refer to FIG. 6. A length of one compressed data block in the first compressed data segment is 64 bits, that is, L=64, and m=|L/S|=|64/3|=|21.3|=21. Therefore, 21 decoder groups may be used to decompress one compressed data block in parallel.

Refer to FIG. 9. For any compressed data block in the first compressed data segment, the length of the first indication information is 1 bit. For a first decoder in a first decoder group, that is, i=0 and j=0, a bit sequence 1 is input to the first decoder in the first decoder group, and the bit sequence 1 includes a zeroth bit to a second bit in the compressed data block. For a second decoder in the first decoder group, that is, i=0 and j=1, a bit sequence 2 is input to the second decoder in the first decoder group, and the bit sequence 2 includes the zeroth bit to a fifth bit in the compressed data block. The first decoder obtains a first bit in the bit sequence 1 as first indication information; and if a codeword length indicated by the first indication information is 2, and the last 2 bits in the bit sequence 1 are a codeword in the target correspondence, obtains original data corresponding to the codeword. Alternatively, the second decoder obtains a first bit in the bit sequence 2 as first indication information; and if a codeword length indicated by the first indication information is 5, and the last 5 bits in the bit sequence 2 are a codeword in the target correspondence, obtains original data corresponding to the codeword.

For a first decoder in a second decoder group, that is, i=1 and j=0, a bit sequence 3 is input to the first decoder in the second decoder group, and the bit sequence 3 includes a third bit to the fifth bit in the compressed data block. For a second decoder in the second decoder group, that is, i=1 and j=1, a bit sequence 4 is input to the second decoder in the second decoder group, and the bit sequence 4 includes the third bit to an eighth bit in the compressed data block. The first decoder obtains a first bit in the bit sequence 3 as first indication information; and if a codeword length indicated by the first indication information is 2, and the last 2 bits in the bit sequence 3 are a codeword in the target correspondence, obtains original data corresponding to the codeword. Alternatively, the second decoder obtains a first bit in the bit sequence 4 as first indication information; and if a codeword length indicated by the first indication information is 5, and the last 5 bits in the bit sequence 4 are a codeword in the target correspondence, obtains original data corresponding to the codeword.

For a third decoder group, a fourth decoder group, ..., and a twenty-first decoder group, a decompression process of each decoder group is not listed one by one.

In some embodiments, the m decoder groups belong to one engine, and the engine decompresses compressed data in one compressed data block in the first compressed data segment. Because the first compressed data segment includes a plurality of compressed data blocks, a plurality of engines may be used to decompress the plurality of compressed data blocks in parallel. That is, the plurality of compressed data blocks are in a one-to-one correspondence with the plurality of engines, and each engine decompresses a compressed data block corresponding to each engine, thereby improving data decompression efficiency.

In this embodiment of this application, any piece of compressed data in the first compressed data segment is obtained, to obtain the first compressed data. The first compressed data includes the first indication information and the codeword, and the first original data is obtained based on the first indication information and the codeword. Because the first compressed data includes the first indication information and a codeword corresponding to the first original data, the first indication information indicates a length of the codeword. Generally, a length of the codeword corresponding to the original data is less than or equal to a length of the original data, so that a compression rate can be improved. The first compressed data includes the first indication information, and the first indication information indicates the length of the codeword. In this way, operation complexity of allocating the codeword corresponding to each type of original data may be simplified, thereby improving compression efficiency. In addition, during data decompression, a plurality of decoder groups may be used to decompress one compressed data block in parallel, thereby improving data decompression efficiency.

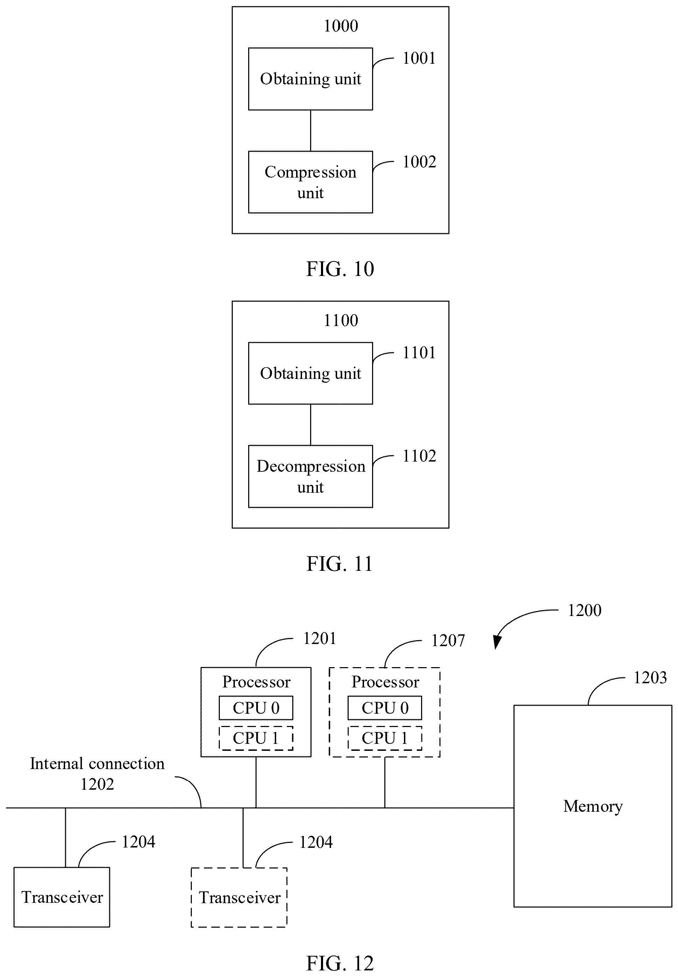

Refer to FIG. 10. An embodiment of this application provides a data compression apparatus 1000. The apparatus 1000 is deployed on the computing device 100 shown in FIG. 1 or FIG. 3, or the apparatus 1000 is deployed on the computing chip in the computing device 100 in the method 400 shown in FIG. 4. The apparatus 1000 includes:
an obtaining unit 1001, configured to obtain a codeword corresponding to to-be-compressed first original data; and
a compression unit 1002, configured to obtain first compressed data corresponding to the first original data, where the first compressed data includes first indication information and the codeword, and the first indication information indicates a length of the codeword.

Optionally, for a detailed implementation process in which the obtaining unit 1001 obtains the codeword, refer to related content in step 402 of the method 400 shown in FIG. 4. Details are not described herein again.

Optionally, for a detailed implementation process in which the compression unit 1002 obtains the first compressed data, refer to related content in step 403 of the method 400 shown in FIG. 4. Details are not described herein again.

Optionally, the obtaining unit 1001 is further configured to:
obtain occurrence frequency of each type of original data included in a to-be-compressed first original data segment and a quantity of types of original data included in the first original data segment, where the first original data segment is a data segment to which the first original data belongs; and
obtain, based on the occurrence frequency of each type of original data included in the first original data segment and the quantity of types of original data included in the first original data segment, the codeword corresponding to the first original data.

Optionally, for a detailed implementation process in which the obtaining unit 1001 obtains the occurrence frequency of each type of original data and the quantity of types of original data included in the first original data segment, refer to related content in step 402 of the method 400 shown in FIG. 4. Details are not described herein again.

Optionally, for a detailed implementation process in which the obtaining unit 1001 obtains the codeword corresponding to the first original data, refer to related content in step 402 of the method 400 shown in FIG. 4. Details are not described herein again.

Optionally, the obtaining unit 1001 is configured to:
obtain a first compression mode based on the quantity of types of original data included in the first original data segment, where a plurality of codeword lengths are defined in the first compression mode, a quantity of types of original data that can be compressed in the first compression mode is greater than or equal to the quantity of types of original data included in the first original data segment, and the quantity of types of original data that can be compressed in the first compression mode is determined based on the plurality of codeword lengths; and
obtain, based on the plurality of codeword lengths defined in the first compression mode and the occurrence frequency of each type of original data included in the first original data segment, the codeword corresponding to the first original data, where the length that is of the codeword and that is indicated by the first indication information is one of the plurality of codeword lengths.

Optionally, for a detailed implementation process in which the obtaining unit 1001 obtains the first compression mode, refer to related content in step 402 of the method 400 shown in FIG. 4. Details are not described herein again.

Optionally, for a detailed implementation process in which the obtaining unit 1001 obtains the codeword corresponding to the first original data, refer to related content in step 402 of the method 400 shown in FIG. 4. Details are not described herein again.

Optionally, the obtaining unit 1001 is further configured to:
obtain a first length, where the first length is equal to a sum of lengths of compressed data corresponding to all original data in a first original data block, and the first original data block is an original data block to which the first original data belongs; and
when the first length is less than a standard block length, obtain a first compressed data block corresponding to the first original data block, where the first compressed data block includes at least one padding bit and the compressed data corresponding to all original data in the first original data block, and a quantity of the at least one padding bit is equal to the standard block length minus the first length.

Optionally, for a detailed implementation process in which the obtaining unit 1001 obtains the first length, refer to related content in step 402 of the method 400 shown in FIG. 4. Details are not described herein again.

Optionally, for a detailed implementation process in which the obtaining unit 1001 obtains the first compressed data block corresponding to the first original data block, refer to related content in step 403 of the method 400 shown in FIG. 4. Details are not described herein again.

Optionally, the first original data block is a data block in the first original data segment, a first compressed data segment corresponding to the first original data segment includes a compressed data block corresponding to each original data block in the first original data segment, the first compressed data segment further includes a data header, the data header includes the first compression mode, and the length of the codeword is equal to one of the plurality of codeword lengths defined in the first compression mode.

Optionally, the first compressed data segment further includes a first correspondence, and the first correspondence includes the first original data and the codeword.

Optionally, the first original data segment includes a plurality of pieces of first data at consecutive positions, the first original data includes second indication information and a quantity of the plurality of pieces of first data, and the second indication information indicates that the first original data includes the quantity of the plurality of pieces of first data.

Alternatively, the first original data segment includes second data, the second data is data other than the first data, the first original data includes third indication information and the second data, and the third indication information indicates that the first original data includes the second data.

In this embodiment of this application, the obtaining unit obtains the codeword corresponding to the to-be-compressed first original data. The compression unit obtains the first compressed data corresponding to the first original data, where the first compressed data includes the first indication information and the codeword, and the first indication information indicates the length of the codeword. The compression unit compresses the first original data into the codeword, and the length of the codeword is less than or equal to a length of the first original data, so that a compression rate may be improved. In addition, because the compression unit uses the first indication information to indicate the length of the codeword, algorithm complexity of allocating the codeword corresponding to the first original data may be simplified, thereby improving compression efficiency.

Refer to FIG. 11. An embodiment of this application provides a data decompression apparatus 1100. The apparatus 1100 is deployed on the computing device 100 shown in FIG. 1 or FIG. 3, or the apparatus 1100 is deployed on the computing chip in the computing device 100 in the method 700 shown in FIG. 7. The apparatus 1100 includes:
an obtaining unit 1101, configured to obtain to-be-decompressed first compressed data, where the first compressed data includes first indication information and a codeword, and the first indication information indicates a length of the codeword; and
a decompression unit 1102, configured to obtain first original data based on the first indication information and the codeword.

Optionally, for a detailed implementation process in which the obtaining unit 1001 obtains the first compressed data block, refer to related content in step 702 of the method 700 shown in FIG. 7. Details are not described herein again.

Optionally, for a detailed implementation process in which the decompression unit 1102 obtains the first original data, refer to related content in step 703 of the method 700 shown in FIG. 7. Details are not described herein again.

Optionally, a first original data segment to which the first original data belongs includes a plurality of original data blocks, the plurality of original data blocks include a first original data block, the first original data block includes the first original data, a first compressed data block corresponding to the first original data block includes compressed data corresponding to all original data in the first original data block, a sum of lengths of all compressed data included in the first compressed data block is equal to a first length, the first length is less than a standard block length, the first compressed data block further includes at least one padding bit, and a quantity of the at least one padding bit is equal to the standard block length minus the first length.

Optionally, a first compressed data segment corresponding to the first original data segment includes a compressed data block corresponding to each original data block in the first original data segment, the first compressed data segment further includes a data header, the data header includes a first compression mode, a plurality of codeword lengths are defined in the first compression mode, a quantity of types of original data that can be compressed in the first compression mode is greater than or equal to a quantity of types of original data included in the first original data segment, the quantity of types of original data that can be compressed in the first compression mode is determined based on the plurality of codeword lengths, and the length that is of the codeword and that is indicated by the first indication information is one of the plurality of codeword lengths.

The decompression unit 1102 is configured to:
obtain the codeword from the first compressed data based on the first indication information and the first compression mode; and
obtain the first original data corresponding to the codeword.

Optionally, for a detailed implementation process in which the decompression unit 1102 obtains the codeword from the first compressed data, refer to related content in step 702 of the method 700 shown in FIG. 7. Details are not described herein again.

Optionally, for a detailed implementation process in which the decompression unit 1102 obtains the first original data corresponding to the codeword, refer to related content in step 703 of the method 700 shown in FIG. 7. Details are not described herein again.

Optionally, the first compressed data segment further includes a first correspondence, and the first correspondence includes the first original data and the codeword.

The decompression unit 1102 is configured to obtain, based on the first correspondence, the first original data corresponding to the codeword.

Optionally, for a detailed implementation process in which the decompression unit 1102 obtains, based on the first correspondence, the first original data corresponding to the codeword, refer to related content in step 703 of the method 700 shown in FIG. 7. Details are not described herein again.

Optionally, the decompression unit 1102 is configured to:
obtain the first original data based on the first indication information and the codeword by using m decoder groups, where each decoder group includes n decoders, n is equal to a quantity of the plurality of codeword lengths defined in the first compression mode, m is equal to |L/S|, L is a length of the first compressed data block, S is a greatest common divisor of n numerical values, the n numerical values include a sum of a codeword length defined in the first compression mode and a length of the first indication information, and | | is a round-down operation.

Optionally, for a detailed implementation process in which the decompression unit 1102 obtains the first original data based on the first indication information and the codeword by using the m decoder groups, refer to related content in step 703 of the method 700 shown in FIG. 7. Details are not described herein again.

Optionally, the decompression unit 1102 is configured to:
input a bit sequence to a j^{th} decoder in an i^{th} decoder group, where the bit sequence includes an (i*S)^{th} bit to an ((i+j+1)*S-1)^{th} bit in the first compressed data block, i=0, 1, 2, ..., or m-1, j=0, 1, 2, ..., or n-1, and * represents a multiplication operation, so that the decoder obtains, based on the first compression mode, a codeword length indicated by first Q bits of the bit sequence, where Q is the length of the first indication information; and when a length of a first part is equal to the codeword length indicated by the first Q bits, and the first part is the same as the codeword, obtains the first original data corresponding to the codeword, where the first part is a part that is in the bit sequence and that is other than the first Q bits.

Optionally, for a detailed implementation process in which the decompression unit 1102 inputs the bit sequence to the j^{th} decoder in the i^{th} decoder group, refer to related content in step 703 of the method 700 shown in FIG. 7. Details are not described herein again.

Optionally, the first original data includes second indication information and a quantity of a plurality of pieces of first data, the second indication information indicates the quantity that is of the plurality of pieces of first data and that is included in the first original data, and the obtaining unit 1101 is further configured to obtain the plurality of pieces of first data based on the second indication information and the quantity.

Optionally, the first original data includes third indication information and second data, the third indication information indicates that the first original data includes the second data, and the obtaining unit is further configured to obtain the second data in the first original data based on the third indication information.

In this embodiment of this application, the obtaining unit obtains the to-be-decompressed first compressed data, where the first compressed data includes the first indication information and the codeword, and the first indication information indicates the length of the codeword. The decompression unit obtains the first original data based on the first indication information and the codeword. The first compressed data includes the first indication information and the codeword, and the length of the codeword is less than or equal to a length of the first original data, so that a compression rate may be improved. In addition, because the first indication information indicates the length of the codeword, algorithm complexity of allocating the codeword corresponding to the first original data may be simplified, thereby improving compression efficiency.

FIG. 12 is a diagram of a data compression apparatus 1200 according to an embodiment of this application. The apparatus 1200 may be the computing chip in any one of the foregoing embodiments. For example, the apparatus 1200 may be the computing chip in the computing device 100 shown in FIG. 1 or FIG. 3, or may be the computing device in the method 400 shown in FIG. 4. The apparatus 1200 includes at least one processor 1201, an internal connection 1202, a memory 1203, and at least one transceiver 1204.

The apparatus 1200 is an apparatus of a hardware structure.

In some embodiments, the apparatus may be configured to implement function modules in the apparatus 1000 in FIG. 10. For example, a person skilled in the art may figure out that the obtaining unit 1001 and the compression unit 1002 in the apparatus 1000 shown in FIG. 10 may be implemented by the at least one processor 1201 by invoking code in the memory 1203.

Optionally, the processor 1201 may be a general-purpose central processing unit (central processing unit, CPU), a network processor (network processor, NP), a microprocessor, an application-specific integrated circuit (application-specific integrated circuit, ASIC), or one or more integrated circuits configured to control program execution of the solutions in this application.

The internal connection 1202 may include a path for transmitting information between the foregoing components. Optionally, the internal connection 1202 is a board, a bus, or the like.

The transceiver 1204 is configured to communicate with another node or a communication network.

The memory 1203 may be a read-only memory (read-only memory, ROM) or another type of static storage device that can store static information and instructions, or a random access memory (random access memory, RAM) or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another optical disk storage, an optical disc storage (including a compact disc, a laser disc, an optical disc, a digital versatile disc, a Blu-ray disc, or the like), a disk storage medium or another magnetic storage device, or any other medium that can be used to carry or store expected program code in a form of instructions or a data structure and that can be accessed by a computer. However, the memory 1203 is not limited thereto. The memory may exist independently, and is connected to the processor by using the bus. Alternatively, the memory may be integrated with the processor.

The memory 1203 is configured to store application program code for executing solutions of this application, and the processor 1201 controls execution of the application program code. The processor 1201 is configured to execute the application program code stored in the memory 1203, and cooperate with the at least one transceiver 1204, so that the apparatus 1200 implements functions in the method in this patent.

During specific implementation, in an embodiment, the processor 1201 may include one or more CPUs, such as a CPU 0 and a CPU 1 in FIG. 12.

During specific implementation, in an embodiment, the apparatus 1200 may include a plurality of processors, such as the processor 1201 and a processor 1207 in FIG. 12. Each of the processors may be a single-core (single-CPU) processor or a multi-core (multi-CPU) processor. Herein, the processor may be one or more devices, circuits, and/or processing cores configured to process data (for example, computer program instructions).

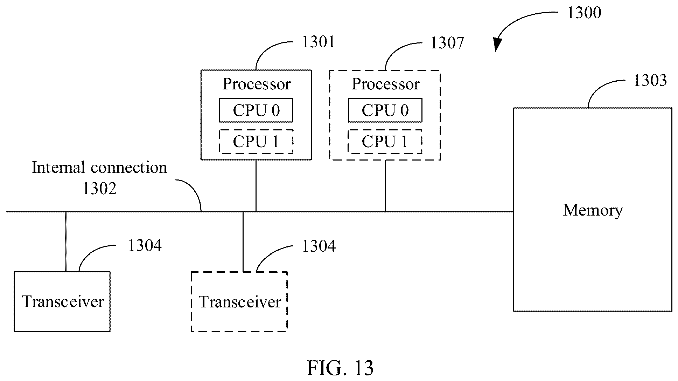

Refer to FIG. 13. An embodiment of this application provides a diagram of a data decompression apparatus 1300. The apparatus 1300 may be the computing chip in any one of the foregoing embodiments. For example, the apparatus 1300 may be the computing chip in the computing device 100 shown in FIG. 1 or FIG. 3, or may be the computing device in the method 700 shown in FIG. 7. The apparatus 1300 includes at least one processor 1301, an internal connection 1302, a memory 1303, and at least one transceiver 1304.

The apparatus 1300 is an apparatus of a hardware structure.

In some embodiments, the apparatus may be configured to implement function modules in the apparatus 1100 in FIG. 11. For example, a person skilled in the art may figure out that the obtaining unit 1101 and the decompression unit 1102 in the apparatus 1100 shown in FIG. 11 may be implemented by the at least one processor 1301 by invoking code in the memory 1303.

Optionally, the processor 1301 may be a general-purpose central processing unit (central processing unit, CPU), a network processor (network processor, NP), a microprocessor, an application-specific integrated circuit (application-specific integrated circuit, ASIC), or one or more integrated circuits configured to control program execution of the solutions in this application.

The internal connection 1302 may include a path for transmitting information between the foregoing components. Optionally, the internal connection 1302 is a board, a bus, or the like.

The transceiver 1304 is configured to communicate with another node or a communication network.

The memory 1303 may be a read-only memory (read-only memory, ROM) or another type of static storage device that can store static information and instructions, or a random access memory (random access memory, RAM) or another type of dynamic storage device that can store information and instructions, or may be an electrically erasable programmable read-only memory (electrically erasable programmable read-only memory, EEPROM), a compact disc read-only memory (compact disc read-only memory, CD-ROM) or another optical disk storage, an optical disc storage (including a compact disc, a laser disc, an optical disc, a digital versatile disc, a Blu-ray disc, or the like), a disk storage medium or another magnetic storage device, or any other medium that can be used to carry or store expected program code in a form of instructions or a data structure and that can be accessed by a computer. However, the memory 1303 is not limited thereto. The memory may exist independently, and is connected to the processor by using the bus. Alternatively, the memory may be integrated with the processor.

The memory 1303 is configured to store application program code for executing solutions of this application, and the processor 1301 controls execution of the application program code. The processor 1301 is configured to execute the application program code stored in the memory 1303, and cooperate with the at least one transceiver 1304, so that the apparatus 1300 implements functions in the method in this patent.

During specific implementation, in an embodiment, the processor 1301 may include one or more CPUs, such as a CPU 0 and a CPU 1 in FIG. 13.

During specific implementation, in an embodiment, the apparatus 1300 may include a plurality of processors, such as the processor 1301 and a processor 1307 in FIG. 13. Each of the processors may be a single-core (single-CPU) processor or a multi-core (multi-CPU) processor. Herein, the processor may be one or more devices, circuits, and/or processing cores configured to process data (for example, computer program instructions).

A person of ordinary skill in the art may understand that all or some of the steps of the foregoing embodiments may be implemented by hardware or a program instructing related hardware. The program may be stored in a computer-readable storage medium. The storage medium may be a read-only memory, a magnetic disk, a compact disc, or the like.

The foregoing description is merely optional embodiments of this application, but is not intended to limit this application. Any modification, equivalent replacement, or improvement made without departing from the principle of this application should fall within the protection scope of this application.

## Claims

1. A data compression method, wherein the method comprises:
obtaining a codeword corresponding to to-be-compressed first original data; and
obtaining first compressed data corresponding to the first original data, wherein the first compressed data comprises first indication information and the codeword, and the first indication information indicates a length of the codeword.

2. The method according to claim 1, wherein the method further comprises:
obtaining occurrence frequency of each type of original data comprised in a to-be-compressed first original data segment and a quantity of types of original data comprised in the first original data segment, wherein the first original data segment is a data segment to which the first original data belongs; and
obtaining the codeword corresponding to the to-be-compressed first original data comprises:
obtaining, based on the occurrence frequency of each type of original data comprised in the first original data segment and the quantity of types of original data comprised in the first original data segment, the codeword corresponding to the first original data.

3. The method according to claim 2, wherein obtaining, based on the occurrence frequency of the original data comprised in the first original data segment and the quantity of types of original data comprised in the first original data segment, the codeword corresponding to the first original data comprises:
obtaining a first compression mode based on the quantity of types of original data comprised in the first original data segment, wherein a plurality of codeword lengths are defined in the first compression mode, a quantity of types of original data that can be compressed in the first compression mode is greater than or equal to the quantity of types of original data comprised in the first original data segment, and the quantity of types of original data that can be compressed in the first compression mode is determined based on the plurality of codeword lengths; and
obtaining, based on the plurality of codeword lengths defined in the first compression mode and the occurrence frequency of each type of original data comprised in the first original data segment, the codeword corresponding to the first original data, wherein the length that is of the codeword and that is indicated by the first indication information is one of the plurality of codeword lengths.

4. The method according to any one of claims 1 to 3, wherein the method further comprises:
obtaining a first length, wherein the first length is equal to a sum of lengths of compressed data corresponding to all original data in a first original data block, and the first original data block is an original data block to which the first original data belongs; and
when the first length is less than a standard block length, obtaining a first compressed data block corresponding to the first original data block, wherein the first compressed data block comprises at least one padding bit and the compressed data corresponding to all original data in the first original data block, and a quantity of the at least one padding bit is equal to the standard block length minus the first length.

5. The method according to claim 4, wherein the first original data block is a data block in the first original data segment, a first compressed data segment corresponding to the first original data segment comprises a compressed data block corresponding to each original data block in the first original data segment, the first compressed data segment further comprises a data header, the data header comprises the first compression mode, and the length of the codeword is equal to one of the plurality of codeword lengths defined in the first compression mode.

6. The method according to claim 5, wherein the first compressed data segment further comprises a first correspondence, and the first correspondence comprises the first original data and the codeword.

7. The method according to any one of claims 2 to 6, wherein the first original data segment comprises a plurality of pieces of first data at consecutive positions, the first original data comprises second indication information and a quantity of the plurality of pieces of first data, and the second indication information indicates that the first original data comprises the quantity of the plurality of pieces of first data; or
the first original data segment comprises second data, the second data is data other than the first data, the first original data comprises third indication information and the second data, and the third indication information indicates that the first original data comprises the second data.

8. A data decompression method, wherein the method comprises:
obtaining to-be-decompressed first compressed data, wherein the first compressed data comprises first indication information and a codeword, and the first indication information indicates a length of the codeword; and
obtaining first original data based on the first indication information and the codeword.

9. The method according to claim 8, wherein a first original data segment to which the first original data belongs comprises a plurality of original data blocks, the plurality of original data blocks comprise a first original data block, the first original data block comprises the first original data, a first compressed data block corresponding to the first original data block comprises compressed data corresponding to all original data in the first original data block, a sum of lengths of all compressed data comprised in the first compressed data block is equal to a first length, the first length is less than a standard block length, the first compressed data block further comprises at least one padding bit, and a quantity of the at least one padding bit is equal to the standard block length minus the first length.

10. The method according to claim 9, wherein a first compressed data segment corresponding to the first original data segment comprises a compressed data block corresponding to each original data block in the first original data segment, the first compressed data segment further comprises a data header, the data header comprises a first compression mode, a plurality of codeword lengths are defined in the first compression mode, a quantity of types of original data that can be compressed in the first compression mode is greater than or equal to a quantity of types of original data comprised in the first original data segment, the quantity of types of original data that can be compressed in the first compression mode is determined based on the plurality of codeword lengths, and the length that is of the codeword and that is indicated by the first indication information is one of the plurality of codeword lengths; and
obtaining the first original data based on the first indication information and the codeword comprises:
obtaining the codeword from the first compressed data based on the first indication information and the first compression mode; and
obtaining the first original data corresponding to the codeword.

11. The method according to claim 10, wherein the first compressed data segment further comprises a first correspondence, and the first correspondence comprises the first original data and the codeword; and
obtaining the first original data corresponding to the codeword comprises:
obtaining, based on the first correspondence, the first original data corresponding to the codeword.

12. The method according to claim 10 or 11, wherein obtaining the first original data based on the first indication information and the codeword comprises:
obtaining the first original data based on the first indication information and the codeword by using m decoder groups, wherein each decoder group comprises n decoders, n is equal to a quantity of the plurality of codeword lengths defined in the first compression mode, m is equal to |L/S|, L is a length of the first compressed data block, S is a greatest common divisor of n numerical values, the n numerical values comprise a sum of a codeword length defined in the first compression mode and a length of the first indication information, and | | is a round-down operation.

13. The method according to claim 12, wherein obtaining the first original data based on the first indication information and the codeword by using the m decoder groups comprises:
inputting a bit sequence to a j^{th} decoder in an i^{th} decoder group, wherein the bit sequence comprises an (i*S)^{th} bit to an ((i+j+1)*S-1)^{th} bit in the first compressed data block, i=0, 1, 2, ..., or m-1, j=0, 1, 2, ..., or n-1, and * represents a multiplication operation, so that the decoder obtains, based on the first compression mode, a codeword length indicated by first Q bits of the bit sequence, wherein Q is the length of the first indication information; and when a length of a first part is equal to the codeword length indicated by the first Q bits, and the first part is the same as the codeword, obtains the first original data corresponding to the codeword, wherein the first part is a part that is in the bit sequence and that is other than the first Q bits.

14. The method according to any one of claims 9 to 13, wherein the first original data comprises second indication information and a quantity of a plurality of pieces of first data, the second indication information indicates the quantity that is of the plurality of pieces of first data and that is comprised in the first original data, and the method further comprises:
obtaining the plurality of pieces of first data based on the second indication information and the quantity.

15. The method according to any one of claims 9 to 13, wherein the first original data comprises third indication information and second data, the third indication information indicates that the first original data comprises the second data, and the method further comprises:
obtaining the second data in the first original data based on the third indication information.

16. A data compression apparatus, wherein the apparatus comprises:
an obtaining unit, configured to obtain a codeword corresponding to to-be-compressed first original data; and
a compression unit, configured to obtain first compressed data corresponding to the first original data, wherein the first compressed data comprises first indication information and the codeword, and the first indication information indicates a length of the codeword.

17. The apparatus according to claim 16, wherein the obtaining unit is further configured to:
obtain occurrence frequency of each type of original data comprised in a to-be-compressed first original data segment and a quantity of types of original data comprised in the first original data segment, wherein the first original data segment is a data segment to which the first original data belongs; and
obtain, based on the occurrence frequency of each type of original data comprised in the first original data segment and the quantity of types of original data comprised in the first original data segment, the codeword corresponding to the first original data.

18. The apparatus according to claim 17, wherein the obtaining unit is configured to:
obtain a first compression mode based on the quantity of types of original data comprised in the first original data segment, wherein a plurality of codeword lengths are defined in the first compression mode, a quantity of types of original data that can be compressed in the first compression mode is greater than or equal to the quantity of types of original data comprised in the first original data segment, and the quantity of types of original data that can be compressed in the first compression mode is determined based on the plurality of codeword lengths; and
obtain, based on the plurality of codeword lengths defined in the first compression mode and the occurrence frequency of each type of original data comprised in the first original data segment, the codeword corresponding to the first original data, wherein the length that is of the codeword and that is indicated by the first indication information is one of the plurality of codeword lengths.

19. The apparatus according to any one of claims 16 to 18, wherein the obtaining unit is further configured to:
obtain a first length, wherein the first length is equal to a sum of lengths of compressed data corresponding to all original data in a first original data block, and the first original data block is an original data block to which the first original data belongs; and
when the first length is less than a standard block length, obtain a first compressed data block corresponding to the first original data block, wherein the first compressed data block comprises at least one padding bit and the compressed data corresponding to all original data in the first original data block, and a quantity of the at least one padding bit is equal to the standard block length minus the first length.

20. The apparatus according to claim 19, wherein the first original data block is a data block in the first original data segment, a first compressed data segment corresponding to the first original data segment comprises a compressed data block corresponding to each original data block in the first original data segment, the first compressed data segment further comprises a data header, the data header comprises the first compression mode, and the length of the codeword is equal to one of the plurality of codeword lengths defined in the first compression mode.

21. The apparatus according to claim 20, wherein the first compressed data segment further comprises a first correspondence, and the first correspondence comprises the first original data and the codeword.

22. The apparatus according to any one of claims 17 to 21, wherein the first original data segment comprises a plurality of pieces of first data at consecutive positions, the first original data comprises second indication information and a quantity of the plurality of pieces of first data, and the second indication information indicates that the first original data comprises the quantity of the plurality of pieces of first data; or
the first original data segment comprises second data, the second data is data other than the first data, the first original data comprises third indication information and the second data, and the third indication information indicates that the first original data comprises the second data.

23. A data decompression apparatus, wherein the apparatus comprises:
an obtaining unit, configured to obtain to-be-decompressed first compressed data, wherein the first compressed data comprises first indication information and a codeword, and the first indication information indicates a length of the codeword; and
a decompression unit, configured to obtain first original data based on the first indication information and the codeword.

24. The apparatus according to claim 23, wherein a first original data segment to which the first original data belongs comprises a plurality of original data blocks, the plurality of original data blocks comprise a first original data block, the first original data block comprises the first original data, a first compressed data block corresponding to the first original data block comprises compressed data corresponding to all original data in the first original data block, a sum of lengths of all compressed data comprised in the first compressed data block is equal to a first length, the first length is less than a standard block length, the first compressed data block further comprises at least one padding bit, and a quantity of the at least one padding bit is equal to the standard block length minus the first length.

25. The apparatus according to claim 24, wherein a first compressed data segment corresponding to the first original data segment comprises a compressed data block corresponding to each original data block in the first original data segment, the first compressed data segment further comprises a data header, the data header comprises a first compression mode, a plurality of codeword lengths are defined in the first compression mode, a quantity of types of original data that can be compressed in the first compression mode is greater than or equal to a quantity of types of original data comprised in the first original data segment, the quantity of types of original data that can be compressed in the first compression mode is determined based on the plurality of codeword lengths, and the length that is of the codeword and that is indicated by the first indication information is one of the plurality of codeword lengths; and
the decompression unit is configured to:
obtain the codeword from the first compressed data based on the first indication information and the first compression mode; and
obtain the first original data corresponding to the codeword.

26. The apparatus according to claim 25, wherein the first compressed data segment further comprises a first correspondence, and the first correspondence comprises the first original data and the codeword; and
the decompression unit is configured to obtain, based on the first correspondence, the first original data corresponding to the codeword.

27. The apparatus according to claim 25 or 26, wherein the decompression unit is configured to:
obtain the first original data based on the first indication information and the codeword by using m decoder groups, wherein each decoder group comprises n decoders, n is equal to a quantity of the plurality of codeword lengths defined in the first compression mode, m is equal to |L/S|, L is a length of the first compressed data block, S is a greatest common divisor of n numerical values, the n numerical values comprise a sum of a codeword length defined in the first compression mode and a length of the first indication information, and | | is a round-down operation.

28. The apparatus according to claim 27, wherein the decompression unit is configured to:
input a bit sequence to a j^{th} decoder in an i^{th} decoder group, wherein the bit sequence comprises an (i*S)^{th} bit to an ((i+j+1)*S-1)^{th} bit in the first compressed data block, i=0, 1, 2, ..., or m-1, j=0, 1, 2, ..., or n-1, and * represents a multiplication operation, so that the decoder obtains, based on the first compression mode, a codeword length indicated by first Q bits of the bit sequence, wherein Q is the length of the first indication information; and when a length of a first part is equal to the codeword length indicated by the first Q bits, and the first part is the same as the codeword, obtains the first original data corresponding to the codeword, wherein the first part is a part that is in the bit sequence and that is other than the first Q bits.

29. The apparatus according to any one of claims 24 to 28, wherein the first original data comprises second indication information and a quantity of a plurality of pieces of first data, the second indication information indicates the quantity that is of the plurality of pieces of first data and that is comprised in the first original data, and the obtaining unit is further configured to obtain the plurality of pieces of first data based on the second indication information and the quantity.

30. The apparatus according to any one of claims 24 to 28, wherein the first original data comprises third indication information and second data, the third indication information indicates that the first original data comprises the second data, and the obtaining unit is further configured to obtain the second data in the first original data based on the third indication information.

31. A data compression apparatus, comprising at least one processor, wherein the at least one processor is configured to be coupled to a memory, and read and execute instructions in the memory, to implement the method according to any one of claims 1 to 7.

32. A data compression apparatus, comprising at least one processor, wherein the at least one processor is configured to be coupled to a memory, and read and execute instructions in the memory, to implement the method according to any one of claims 8 to 15.

33. A data decompression system, wherein the system comprises the apparatus according to any one of claims 16 to 22 and the apparatus according to any one of claims 23 to 30, or the system comprises the apparatus according to claim 31 and the apparatus according to claim 32.

34. A computer storage medium, storing a computer program, wherein when the computer program is executed by a processor, the method according to any one of claims 1 to 15 is implemented.

35. A computer program product, comprising a computer program, wherein when the computer program is executed by a processor, the method according to any one of claims 1 to 15 is implemented.
